# EUROPÄISCHE PATENTANMELDUNG

(11) **EP 2 151 830 A1**
(43) Veröffentlichungstag der Anmeldung: **10.02.2010**
(21) Anmeldenummer: 08162124.5
(22) Anmeldetag: 08.08.2008
(51) Int. Cl.: H01B 1/24

(54) **Polymerformkörper mit leitfähigen Strukturen auf der Oberfläche, sowie Verfahren zu dessen Herstellung**

(71) Anmelder: pp-mid GmbH, 07745 Jena (DE)
(72) Erfinder: Putsch, Peter, 91080 Rathsberg (DE)
(74) Vertreter: Westendorp, Michael Oliver

(57) **Zusammenfassung**

Die vorliegende Erfindung betrifft ein Verfahren zur Erzeugung leitfähiger Strukturen auf der Oberfläche von nicht oder nur gering leitfähigen Polymerformkörpern, umfassend die folgenden Schritte:
a) Bereitstellen eines Polymerformkörpers aus mindestens einer Polymerphase, die Carbon Nanotubes (CNT) enthält;
b) thermische Behandlung mindestens einer Oberfläche des Polymerformkörpers zur Erzeugung der leitfähigen Strukturen auf der Oberfläche, wobei die thermische Behandlung ein Erhitzen auf eine Temperatur umfasst, die mindestens der Schmelztemperatur der mindestens einen Polymerphase entspricht.

Des Weiteren betrifft die Erfindung einen Polymerformkörper, umfassend mindestens eine Polymerphase und zwischen 0,01 und 10 Gew.-% Carbon Nanotubes (CNT), bezogen auf die Polymerphase/n, wobei der Polymerformkörper auf der Oberfläche elektrisch leitfähige Strukturen aufweist, wobei die Konzentration der CNT in den Bereichen der elektrisch leitfähigen Oberflächenstrukturen höher ist als in den nicht elektrisch leitfähigen Oberflächenbereichen.

## Beschreibung

Die vorliegende Erfindung betrifft Polymerformkörper mit leitfähigen, insbesondere elektrisch leitfähigen, Strukturen auf der Oberfläche, sowie ein Verfahren zur Herstellung dieser Polymerformkörper.

Elektrisch leitfähige Kunststoffe sind seit langem bekannt. US 4,404,125 beschreibt die Herstellung derartiger Kunststoffe durch Beimengung von Kohlenstofffasern, gegebenenfalls zusammen mit leitfähigen Rußen, in einen thermoplastischen Kunststoff. In US 4,664,971 werden an Stelle der Kohlenstofffasern elektrisch leitfähige Metallfasern eingesetzt. In all diesen Kunststoffmischungen sind große Mengen an elektrisch leitfähigen Zusatzstoffen erforderlich, die im Regelfall in einem Bereich von 10 - 30 Gew.-% liegen. Dennoch ist die elektrische Leitfähigkeit dieser Kunststoffe, insbesondere an der Oberfläche, noch nicht ausreichend für viele technische Anwendungen.

WO 02/19346 beschreibt den Einsatz metallbeschichteter Carbonfasern zur Herstellung elektrisch leitfähiger Kunststoffe. Hierbei wird z.B. ein energiereicher Laser eingesetzt, um den an der Oberfläche befindlichen Kunststoff zu verdampfen und die darunterliegenden Schichten der elektrisch leitfähigen Zusatzstoffe freizulegen. Ein Nachteil ist die dabei häufig auftretende Leitfähigkeit über das ganze Volumen Des Kunststoffes, auch quer zur und über die laserbehandelte Bahn hinaus, und die resultierenden Probleme bei der Anordnung von nebeneinander liegenden Leiterbahnen.

Ein anderes Verfahren zur Erzeugung elektrisch leitfähiger Strukturen auf beliebigen Substratmaterialien wird in der DD 263 179 beschrieben, wobei die Substratmaterialien mit einem elektrisch leitfähigen Zusatzstoff und Vernetzungsinitiatoren enthaltendem Prepolymer beschichtet, das Prepolymer durch Einwirken energiereicher Strahlen gezielt vernetzt und die nicht vernetzten Anteile der Kunststoffmischung mit Hilfe geeigneter Lösungsmittel wieder entfernt werden. Dieses Verfahren ist sehr aufwendig und mit nicht unerheblichen Problemen hinsichtlich einer ausreichenden Haftung der Strukturen auf der Substratoberfläche verbunden.

Die DE 102 59 498 beschreibt elektrisch leitfähige Thermoplaste, in denen neben teilchenförmigen Kohlenstoffmodifikationen wie Ruß oder Graphit auch Carbon Nanotubes (CNT) eingesetzt werden. Durch Zusatz von derartigen Kohlenstoff-Modifikationen lässt sich die elektrische Leitfähigkeit im Vergleich zu Metallfasern schon bei geringen Zusatzmengen realisieren. Die elektrische Leitfähigkeit verteilt sich dabei mehr oder weniger gleichmäßig über das gesamte Kunststoffvolumen und die Oberfläche. Dabei tritt die elektrische Leitfähigkeit in der Regel erst oberhalb einer gewissen Mindestzusatzmenge an elektrisch leitfähigen Zusatzstoffen auf. Unterhalb dieser Konzentration ist die Leitfähigkeit nahezu auf dem Ausgangsniveau der nicht leitfähigen Kunststoffe. Die Grenze, ab der Leitfähigkeit zu beobachten ist, richtet sich im Wesentlichen nach dem Kunststoff selbst, dem zugesetzten Füllstoff bzw. der zugesetzten Füllstoffmischung sowie nach den Misch- und Verarbeitungsbedingungen, denen die Kunststoffmischung unterzogen worden ist.

Um eine gute elektrische Leitfähigkeit zu erzielen, sind bei all diesen Verfahren ausreichende Mengen an Zusatzstoffen erforderlich und die Leitfähigkeit ist weitgehend gleichmäßig über das Volumen der Kunststoffformteils verteilt. Mit dem steigenden Füllgrad ist aber im Regelfall eine Verschlechterung der mechanischen Eigenschaften verbunden, so dass bei hohen Füllgraden beispielsweise die Zähigkeit sowie Zug- und Reißfestigkeit deutlich reduziert sind.

Eine weitere Möglichkeit zur Erzeugung elektrisch leitfähiger Strukturen auf Oberflächen wurde von T. Dekker (Carbon-Nanotubes as Molecular Quantum Wires, Physics Today, S. 22-28, 1999) beschrieben. Hierbei werden Carbon Nanotubes aus der Gasphase auf einem Substrat abgeschieden. Dieses Verfahren ist ebenfalls mit einem hohen technischen Aufwand verbunden.

Eine Aufgabe der vorliegenden Erfindung war es daher, die bekannten Verfahren zur Erzeugung von leitfähigen Strukturen auf Polymerformkörpern zu vereinfachen und zu verbessern und insbesondere Polymerformkörper mit besonders guten Eigenschaften zur Verfügung zu stellen.

Die oben beschriebene Aufgabe wird durch die in den Ansprüchen definierten Polymerformkörper und das Verfahren zu deren Herstellung gelöst.

Im Rahmen der vorliegenden Erfindung wurde überraschenderweise festgestellt, dass das partielle Anschmelzen der Oberfläche eines Polymerformkörpers, der Carbon Nanotubes enthält, zu einer Migration der CNT an die Oberfläche des Polymerformkörpers führt. Durch gezieltes Anschmelzen der Oberfläche in definierten Bereichen ist es somit auf vorteilhafte Weise möglich, die Konzentration der CNT in diesen Bereichen zu erhöhen und die elektrische und thermische Leitfähigkeit dieser Bereiche zu erhöhen. Ein Nachweis für die höhere Konzentration der CNT in den elektrisch leitfähigen (thermisch behandelten) Bereichen kann z. B. über lichtmikroskopische oder elektronenmikroskopische Aufnahmen geliefert werden. Hierbei erscheinen beispielsweise bei einem Polymerformkörper aus Polycarbonat und CNT im Lichtmikroskop die Stellen mit hoher CNT-Dichte in schwarzer Farbe, wohingegen die Stellen mit geringer CNT-Dichte weiß sind.

Im Gegensatz dazu wurde im Rahmen der vorliegenden Erfindung überraschenderweise festgestellt, dass die Verwendung von Polymerformkörpern mit anderen elektrisch leitenden Zusatzstoffen nicht zu einer Migration der leitfähigen Stoffe an die Oberfläche führt. Beispielsweise führte das Anschmelzen von Polymerformkörpern mit leitfähigen Fasersystemen, wie z. B. Aluflakes (Hersteller Alufllakes der Fa. Silverline, GB; verwendete Polymermischung Polycarbonat/Polypropylen, siehe Beispiel) oder Stahlfasern nicht zu einer Migration der leitfähigen Fasern an die Oberfläche. Bei diesen Polymerformkörpern ist daher nur das oben beschriebene Verfahren aus WO 02/19346 anwendbar. Im erfindungsgemäßen Verfahren ist jedoch vorteilhafterweise kein Verdampfen des Polymers auf der Oberfläche des Polymerformkörpers notwendig.

Bei dem erfindungsgemäßen Verfahren ist die Geschwindigkeit der Migration sowohl von der Viskosität der Polymerphasen, durch die sich die CNT bewegen müssen, als auch von der jeweilige Kompatibilität der Oberflächen der CNT und der Polymerphasen, und von der Behandlungsdauer, d.h. der Zeit, die den CNT zur Verfügung steht, um durch das aufgeschmolzene Polymer an die Oberfläche vorzudringen, abhängig. Je länger die Anschmelzung erfolgt, desto besser können die CNT an die Oberfläche wandern, und desto besser ist auch die Erhöhung der elektrischen Leitfähigkeit in den thermisch behandelten Bereichen.

Des Weiteren wurde überraschenderweise festgestellt, dass sich durch Dehnen oder Verbiegen des Polymerformkörpers der Oberflächenwiderstand desselben ändert. Insbesondere wird der Oberflächenwiderstand grösser je mehr der Polymerformkörper gedehnt wird. Dies ermöglicht die Anwendung der erfindungsgemäßen Polymerformkörper in Dehnungsmessstreifen.

Die vorliegende Erfindung betrifft daher Polymerformkörper mit leitfähigen, insbesondere elektrisch leitfähigen, Strukturen auf der Oberfläche, sowie ein Verfahren zur Herstellung dieser Polymerformkörper.

Ein Polymerformkörper im Sinne der vorliegenden Erfindung ist ein beliebig geformter dreidimensionaler Körper oder eine Polymerschicht aus einem oder mehreren verschiedenen Polymeren, die nachfolgend sowohl für das erfindungsgemäße Verfahren als auch für die erfindungsgemäßen Polymerformkörper beschrieben werden.

Erfindungsgemäß geeignete Polymere sind Thermoplaste, Duroplaste, Elastomere sowie anorganische Polymere und Mischung daraus, bevorzugt werden Thermoplaste und Duroplaste verwendet. Bevorzugte Polymere sind Polycarbonat, Acrylnitril-Butadien-Styrol (ABS), Polyamide wie Polyamid 6 (PA 6), Polyamid 6.6 (PA 6.6), Polyamid 6.4 (PA6.4)), Polyamid 12 (PA 12), aromatisches Polyamid, Polyvinylchlorid, Nylon 6,6, Polyvinylfluorid, Polyvinylidenfluorid, Polyphenylenether, Polystyrol, Polyolefine wie Polypropylen oder Polyethylen, Polysulfon, thermoplastisches Polyurethan, Polyethylenterephthalat, Polybutylenterephthalat, thermoplastische Elastomerlegierungen, Acetal, Styrol-Maleinsäureanhydrid, Butadien-Styrol, Polyetheretherketon, Polyethersulfon, Polytetrafluorethen, Polyalkylacrylate, Polymethylmethacrylat, ungesättigte Polyester, Polylactone, Polyepoxide, Polyimine, Polybutadiene, Polyphosphazene, Styrolmaleinsäureanhydrid (SMA), Styrolmethylmethacrylat (SMMA), Polysulfon, Polyvinylacetat und Polyacrylamid. Des Weiteren kann Phenolharz, Polyesterharz, natürlicher oder synthetischer Kautschuk oder Silikonkautschuk verwendet werden. Spezielle Beispiele anorganischer Polymere umfassen Phosphor basierte Verbindungen und Silikone. Die vorstehend aufgezählten Polymere können auf dem Fachmann bekannte Weise hergestellt und verarbeitet werden. Bevorzugterweise werden mindestens zwei, weiter bevorzugt mindestens drei, verschiedene Polymere zur Herstellung des Polymerformkörpers verwendet.

Bevorzugte Polymerblends sind: Polycarbonat/ Polyolefin (insbesondere Polypropylen oder Polyethylen), Polyethylenterephthalate (PET)/ Polyvinylidenfluorid, PET/Nylon 6,6, PET/Polypropylen, PET/Polyethylenmischungen mit hoher Dichte, Polyamid 6 (PA6)/ Acrylonitril-Butadiene-Styrol und Polycarbonat/ Polyolefine (bevorzugt Polypropylen), Polyamid 6 (PA6)/ Polyamid 12 (PA12), Polyamid 6.6 (PA 6.6)/ Polyamid 12 (PA 12), aromatisches Polyamid/ Polyamid 12 (PA 12), Polybutylenterephthalat/ thermoplastisches Polyester, und Polyethylenterephthalat/ thermoplastisches Polyester. Geeignete Polymerblends wurden beispielsweise von Wu et al. (Journal of applied polymer science, 2006, vol. 99, no2, pp. 477-488) im Zusammenhang mit CNT beschrieben. Bei Verwendung mehrerer verschiedener Polymere kann, je nach Eigenschaft der Polymere, ein einphasiges oder mehrphasiges System entstehen.

Erfindungsgemäß besteht der Polymerformkörper bevorzugt aus mindestens zwei miteinander im Wesentlichen nicht mischbaren (phasenunverträglichen) Polymeren. Werden zwei oder mehr phasenunverträgliche Polymere verwendet, so können diese selbst nach dem Anschmelzen des Polymerformkörpers ein zwei- oder mehrphasiges System ausbilden. Phasenunverträgliche Systeme sind dem Fachmann bekannt. Werden die beiden Polymersorte vermengt, liegen sie in getrennten Phasen nebeneinander vor. Wird eine derartige Mischung über einen längeren Zeitraum in der Schmelze gehalten, koaleszieren die aus jeweils einer Polymersorte gebildeten Domänen, d.h. es findet eine Phasenseparierung statt.

Beispielsweise sind Polymere, ausgewählt aus der Gruppe bestehend aus Polystyrol (PS), Polymethylmetacrylat (PMMA) und Acrylnitrit-Butadien-Styrol (ABS), sowie thermoplastischen Polyestern, wie Polyethylenterephthalat (PET) oder Polybutylenterephthalat (PBT), und Polycarbonate nicht mischbar mit Polypropylen und/oder Polypropylencopolymeren. Des Weiteren sind Polystyrol und Polyamid-6 nicht mit Polyethylen oder Polypropylen mischbar. Kombinationen aus zwei oder mehr der vorstehend genannten Polymere sind erfindungsgemäß bevorzugt, wobei die Verwendung von Polycarbonat in Kombination mit Polypropylen besonders bevorzugt ist.

Bei Verwendung von Polypropylen und/oder einem Polypropylencopolymer in einem Gemisch mit dazu phasenunverträglichen Polymeren ist es bevorzugt, jeweils bezogen auf die gesamte Masse des Polymergemisches (inklusive der eventuell verwendeten Hilfsstoffe und Carbon Nanotubes), mindestens 40 Gew.-%, weiter bevorzugt mindestens 60 Gew.-%, noch weiter bevorzugt mindestens 80 Gew.-%, weiter bevorzugt mindestens 90 Gew.-%, und am meisten bevorzugt mindestens 99 Gew.-%, Polypropylen und/oder Polypropylencopolymer zu verwenden. Weitere bevorzugte Mengenbereich sind: 40 bis 99 Gew.-%, weiter bevorzugt 60 bis 95 Gew.-%, noch weiter bevorzugt 70 bis 95 Gew.-%, Polypropylen und/oder Polypropylencopolymer.

Carbon Nanotubes (CNT), auch Kohlenstoffnanoröhrchen oder Kohlenstoffnanotubes genannt, sind aus Kohlenstoffatomen in bestimmter molekularer Anordnung ausgebildete, faserartige Strukturen. CNT bestehen aus Wandabschnitten, die Hohlräume umschließen. Die Wände sind hierbei aus Kohlenstoffatomen mit jeweils drei Bindungspartnern aufgebaut, die eine wabenartige Struktur aus Sechsecken bilden. Je nach Anordnung der Wandstrukturen spricht man von einlagigen Kohlenstoffnanotubes (single wall carbon nanotubes, SWCNT), die aus einzelnen Röhren aufgebaut sind und einen Innendurchmesser von 1-3 nm aufweisen, oder von mehrlagigen Kohlenstoffnanotubes (multi wall carbon nanotubes, MWCNT), die aus mehreren konzentrisch ineinander geschachtelten Röhren bestehen. Die Außendurchmesser der Carbon Nanotubes betragen zwischen 1 nm und 400 nm, wobei Carbon Nanotubes mit einem Außendurchmesser zwischen 10 und 400 nm häufig als Kohlenstoffnanofaser (Carbon Nano Fibre, CNF) bezeichnet werden.

Die Herstellung von Carbon Nanotubes ist dem Fachmann bekannt und kann beispielsweise im Lichtbogenverfahren (Iijima, Nature 354, 1991, 56-8) oder mittels Abscheideverfahren aus der Gasphase (Chemical Vapor Deposition, CVD) erfolgen (P. M. Ajayan, Nanotubes from Carbon, Chem. Rev. 99, S. 1787-1799, 1999). Ein weiteres Verfahren ist in der WO 99/13127, DE 19946182 und WO 98/39250 beschrieben. Hierbei dienen gepulste Laser zur Verdampfung von kohlenstoffhaltigen Materialien, die in einer Vakuumkammer angeordnet sind. Ein Teil der verdampften Kohlenstoffmoleküle kondensiert auf sogenannten Auffängern, deren Temperatur durch externe Heizung und Kühlung gesteuert wird wodurch das Wachstum von Nanoröhren bewirkt wird. Weitere Herstellungsmethoden umfassen beispielsweise Lichtbogen-, Laserablations und katalytische Verfahren. WO 86/03455 und WO 2006/050903 beschreiben Herstellungsverfahren, worin aliphatische oder aromatische Kohlenwasserstoffe in Gegenwart eines Eisen enthaltenden Katalysators bei Temperaturen von 800-900°C zersetzt werden. Bei den bekannten Verfahren werden oft Ruß, amorpher Kohlenstoff und Fasern mit hohen Durchmessern als Nebenprodukte gebildet. Bei der katalytische Abscheidung von Kohlenstoff aus gasförmigen Kohlenwasserstoffen (Catalytic Carbon Vapour Deposition) können beispielsweise Acetylen, Methan, Ethan, Ethylen, Butan, Buten, Butadien, oder Benzol verwendet werden. Als Katalysatoren können z.B. Metalle wie Fe oder Ni oder auch Metalloxide verwendet werden. Die unter Verwendung der vorstehenden Verfahren hergestellten Carbon Nanotubes fallen meist als CNT-Pulver an und können direkt mit den Polymeren vermischt werden. Erfindungsgemäß werden bevorzugt CNT mit einem mittleren Durchmesser von 2 bis 100 nm, weiter bevorzugt 5 bis 80 nm, und besonders bevorzugt 6 bis 50 nm verwendet. Bevorzugt werden MWCNT verwendet. Des Weiteren ist dem Fachmann bekannt, dass die Carbon Nanotubes je nach Symmetrie bzw. Anordnung der Kohlenstoffsechsecke in den Röhrenwänden unterschiedliche Elektronenzustände aufweisen und somit Eigenschaften von Metallen oder Halbleitern aufweisen können. Je nach Anwendung wird der Fachmann daher die geeigneten, in der Literatur beschriebenen, Carbon Nanotubes auswählen können.

Erfindungsgemäß können auch "funktionalisierte Carbon Nanotubes" verwendet werden, solange diese Carbon Nanotubes sich nicht derart mit den Polymeren verbinden, dass eine Migration verhindert wird. "funktionalisierte Carbon Nanotubes" weisen eine modifizierte Oberfläche auf und sind beispielsweise in US 6,203,814 und US 08/812,856 beschrieben.

Anstelle von oder zusätzlich zu den Carbon Nanotubes können nach einer möglichen erfindungsgemäßen Ausführungsform auch Graphene anstelle der CNTs oder zusammen mit diesen eingesetzt werden. Graphene und Verfahren zu deren Herstellung sind dem Fachmann bekannt. Graphene sind einatomare Graphitschichten, die beispielsweise durch epitaktisches Aufwachsen auf einem Siliziumoxid-Substrat hergestellt werden können. CNTs sind erfindungsgemäß jedoch bevorzugt.

Erfindungsgemäß bevorzugt werden Carbon Nanotubes in einem Mengenanteil (bezogen auf die Gesamtmasse der Polymerphase/n des Polymerformkörpers) verwendet, so dass der Polymerformkörper ohne die erfindungsgemäßen leitfähigen Strukturen nicht oder nur gering leitfähig ist. Bei reinen Polycarbonatwerkstoffen können daher beispielsweise insgesamt nur weniger als etwa 5 Gew.-% an CNT eingesetzt werden. Für Polypropylen können maximal etwa 8 - 10 Gew.-% CNT verwendet werden. Ein Fachmann wird je nach Anwendung des erfindungsgemäßen Polymerformkörpers die geeignete Gesamtmenge an CNT durch Testversuche bestimmen.

Zusätzlich bevorzugt können im erfindungsgemäßen Verfahren bzw. in den erfindungsgemäßen Polymerformkörpern Nanocomposits verwendet werden. Derartige Stoffe und deren Anwendung sind dem Fachmann bekannt und beispielsweise in der EP 1 776 418 beschrieben. Bevorzugt werden hierbei Nano-Schichtsilikate, wie beispielsweise Aluminiumschichtsilikat, verwendet. Bevorzugterweise werden Nanocomposits in einem Anteil, bezogen auf die Gesamtmasse der Polymerphase/n im Polymerformkörper, von 0,1 bis 10 Gew.-%, vorzugsweise von 0,5 bis 5 Gew.-%, insbesondere bevorzugt von 0,5 bis 2 Gew.-% eingesetzt.

Zusätzlich bevorzugt kann/können die Polymerphase/n des Polymerformkörpers weitere Stoffe enthalten, die die elektrische Leitfähigkeit des Polymerformkörpers erhöhen können. Beispielsweise können metallbeschichtete Carbonfaser oder ähnliches enthalten sein.

Zusätzlich bevorzugt enthält der Polymerformkörper außer polymeren Bestandteilen, CNT und Nanocomposits maximal 20 Gew.-%, weiter bevorzugt maximal 10 Gew.-%, an weiteren Stoffen wie Verarbeitungshilfsmittel, Dispergierhilfsmittel, Haft- und Verträglichkeitsvermittler, Licht- und Alterungsschutzmittel, Farbstoffe etc.

Der Ausdruck "elektrisch leitfähig", so wie hier verwendet, bezeichnet einen Körper mit einem Oberflächenwiderstand von weniger als 10⁹, bevorzugt weniger als 10⁷ Ohm, weiter bevorzugt weniger als 10⁵, und besonders bevorzugt weniger als 10⁴ Ohm. Dementsprechend betreffen die Ausdrücke "nicht elektrisch leitfähig" und "gering elektrisch leitfähig", so wie hier verwendet, einen Körper mit einem Oberflächenwiderstand von mehr als 10⁹ Ohm, bevorzugt mehr als 10⁷ Ohm, weiter bevorzugt mehr als 10⁵, und besonders bevorzugt mehr als 10⁴ Ohm. Durch das erfindungsgemäße Verfahren ist es möglich, den Oberflächenwiderstand in definierten Bereichen um den Faktor 10, insbesondere 100, insbesondere 1000 oder mehr zu verringern, um elektrisch leitfähige Strukturen zu erzeugen.

Eine elektrisch leitfähige Struktur im Sinne der vorliegenden Erfindung ist eine geometrische Anordnung von elektrisch leitfähigen Bereichen auf der Oberfläche eines Polymerformkörpers, wobei die elektrisch leitfähigen Bereiche an elektrisch nicht leitfähige Bereiche auf der Oberfläche angrenzen. Insbesondere können die elektrisch leitfähigen Strukturen für elektronische Anwendungen ausgebildet sein. Die elektrisch leitfähigen Strukturen können daher beliebige geometrische Formen aufweisen, insbesondere die Form von Linien, Flächen oder Mustern, vorzugsweise immer abgegrenzt durch nicht behandelte (und somit nicht elektrisch leitfähige) Bereiche.

Zusätzlich zu der elektrischen Leitfähigkeit erhöht sich auch die thermische Leitfähigkeit der thermisch behandelten Bereiche der Oberfläche des Polymerformkörpers. Dies ermöglicht weitere technische Anwendungsmöglichkeiten.

Das erfindungsgemäße Verfahren umfasst in einem ersten Schritt das Bereitstellen eines Polymerformkörpers aus mindestens einer Polymerphase, die Carbon Nanotubes (CNT) enthält.

Hierbei wird/werden ein oder mehrere der oben aufgeführten Polymere, unter Schmelzen der Polymere, mit den Carbon Nanotubes vermischt. Die Vermischung der einzelnen Bestandteile kann in an sich beliebiger Weise erfolgen. Bekannte Verfahren zur Herstellung von Polymeren mit CNT bestehen darin, das synthetisierte Polymer, welches regelmäßig als Granulat, Pulver oder auch in Blockform vorliegt, durch Wärmezufuhr aufzuschmelzen und so in einen flüssigviskosen Zustand zu überführen. Dadurch kann die Viskosität des Polymers abgesenkt, und die CNT in das Polymer eingemischt werden. Ein solches Verfahren kann der US 4,157,325 entnommen werden. Aus der kanadischen Offenlegungsschrift CA 2,324,353 A1 ist bekannt, Füllstoffe in ein Monomer einzumischen, eine in-situ-Polymerisation zu starten und den so synthetisierten Thermoplast nachfolgend aufzuschmelzen, um weitere Füllstoffe darin einzubringen. Hierbei können die Carbon Nanotubes vor oder während dem Schmelzvorgang zugeben werden.

Zum Einmischen von Stoffen in niederviskose Kunststoffvorprodukte können beispielsweise die bekannten Dispergierverfahren unter Verwendung einer Perlmühle, Ultraschallsonde, einem Dreirollenwalzwerk oder einem Hochdruckdispergator eingesetzt werden. Zum Einmischen in hochviskose Kunststoffschmelzen finden die bekannten Verfahren wie z.B. der Einsatz von gleichlaufenden Doppelschneckenextrudern z.B. von der Fa. Coperion (DE) oder Fa. Leistritz (DE), von gegenläufigen Doppelschneckenextrudern Fa. Pomini (IT) und Fa. Farell (US) oder der von der Fa. Buss (CH) hergestellte Ko-Kneter Verwendung.

Diese Verfahren können auch eingesetzt werden, wenn phasenunverträgliche Polymere verwendet werden. Beispielsweise können Polypropylen und/oder Polypropylencopolymer mit phasenunverträglichen Polymeren auf diese Weise vermischt und dann gemeinsam aufgeschmolzen und vermengt werden. Bei Verwendung von Nanocomposits können diese ebenfalls vor oder während dem Aufschmelzen zugegeben werden.

Bevorzugterweise wird/werden die Polymerphase/n durch Vermischen von geschmolzenem Polymer mit 0,1-10 Gew.-% Carbon Nanotubes, bezogen auf die Gesamtmasse der Polymerphase/n des Polymerformkörpers, hergestellt.

Zudem ist es möglich, das Vermischen aller Bestandteile in mehreren, aufeinander folgenden Arbeitsschritten durchzuführen. Beispielsweise kann zunächst ein Polymer mit den Carbon Nanotubes unter Schmelzen vermischt und das so erhaltene Masterbatch in einem nachfolgenden Schritt, beispielsweise nach dem Abkühlen und Granulieren, mit den übrigen Polymeren vermischt und geschmolzen werden. Die Herstellung derartiger Masterbatches ist z.B. in US 5,643,502 beschrieben. Durch den Einsatz derartiger Masterbatches kann die Verteilung der Carbon Nanotubes in der Kunststoffmasse verbessert werden.

Hierbei ist es zusätzlich bevorzugt, dass der Polymerformkörper durch Verschmelzen mindestens einer Polymerphase, die Carbon Nanotubes (CNT) in einem Anteil (bezogen auf die Polymerphase) zwischen 1 und 40 Gew.-%, weiter bevorzugt zwischen 5 und 30 Gew.-%, weiter bevorzugt 15 und 30 Gew.-%, enthält, mit mindestens einer weiteren Polymerphase mit geringerem Carbon Nanotubes (CNT)-Anteil, erhalten wird. Hierbei sollte der Gesamtgehalt an CNT dennoch nicht so hoch sein, dass der Polymerformkörper bereits ohne die erfindungsgemäßen leitfähigen Strukturen leitfähig ist. Die Polymerphasen mit unterschiedlichen Carbon Nanotubes (CNT)-Anteilen können hierbei, wie oben beschrieben, unter Verschmelzen der Polymere oder Polymergemische mit den Carbon Nanotubes erhalten werden. Weiter bevorzugt wird die Polymerphase mit dem höheren Carbon Nanotubes-Anteil in geringeren Gewichtsanteilen als die Polymerphasen mit niedrigeren Carbon Nanotubes-Anteilen verwendet. Bevorzugt weisen die Polymerphasen mit niedrigeren Carbon Nanotubes-Anteilen zwischen 0 und 10 Gew.-% CNT (bezogen auf die Polymerphase), weiter bevorzugt zwischen 0 und 5 Gew.-% CNT, auf. Bevorzugterweise wird die Polymerphase mit dem höheren Carbon Nanotubes-Anteil in einem Anteil zwischen 0,5 und 40 Gew.-%, weiter bevorzugt zwischen 1 und 40 Gew.-%, weiter bevorzugt zwischen 1 und 30 Gew.-%, weiter bevorzugt zwischen 1 und 20 Gew.-%, und am meisten bevorzugt zwischen 1 und 10 Gew.-%, bezogen auf die Gesamtmasse der Polymerphasen des Polymerformkörpers, enthalten sein.

Es hat sich überraschenderweise gezeigt, dass die Verwendung von zwei phasenunverträglichen Polymerphasen, von denen eine Polymerphase einen hohen Carbon Nanotubes-Anteil aufweist, eine besonders hohe Leitfähigkeit der erzeugten Strukturen ermöglicht. Es hat sich hierbei gezeigt, dass die Polymerphasen auch nach dem Schmelzen (bei der Herstellung des Polymerformkörpers) noch unterschiedliche Carbon Nanotubes-Anteile aufweisen. Im Gegensatz dazu führt die bekannte Verwendung von Masterbatches mit erhöhtem Ruß-Anteil, beispielsweise bei Verfahren zur Einfärbung von Polymerformkörpern, zu einer gleichmäßigen Verteilung der Rußpartikel auf die Polymerphasen.

Weiter bevorzugt wird hierbei die Polymerphase, die Carbon Nanotubes (CNT) in einem höheren Anteil enthält, aus einem oder mehreren Polymeren, ausgewählt aus der Gruppe bestehend aus Polycarbonat, Polystryrol, Acrylnitrit-Butadien-Styrol (ABS), Styrolmaleinsäureanhydrid (SMA), Styrolmethylmethacrylat (SMMA), Polymethylmethacrylat (PMMA), Polybutylenterephthalat (PBT), Polyethylenterephthalat (PET), Polyamid 6 (PA 6), Polyamid 6.6 (PA 6.6), Polyamid 6.4 (PA6.4), Polyamid 12 (PA 12), aromatischem Polyamid, Polysulfon, hergestellt. Bevorzugterweise besteht diese Polymerphase zu mindestens 50 Gew.-%, weiter bevorzugt zu mindestens 60 Gew.-%, weiter bevorzugt zu mindestens 70 Gew.-%, noch weiter bevorzugt zu mindestens 80 Gew.-%, und am meisten bevorzugt zu mindestens 90 Gew.-% aus Polycarbonat.

Die gewünschten Polymerformkörper können dann auf übliche Weise durch Extrusions- oder Spritzgussverfahren aus den Polymergemischen erhalten werden.

In einem zweiten Schritt des erfindungsgemäßen Verfahrens erfolgt eine thermische Behandlung mindestens einer Oberfläche des Polymerformkörpers zur Erzeugung der leitfähigen, insbesondere der elektrisch leitfähigen, Strukturen auf der Oberfläche des Polymerformkörpers, wobei die thermische Behandlung das Erhitzen des Bereichs der Oberfläche auf eine Temperatur umfasst, die mindestens der Schmelztemperatur der mindestens einen Polymerphase entspricht. Nach einer bevorzugten Ausführungsform erfolgt nach dem Abkühlen der thermisch behandelten Bereiche (bis sich die Polymerphasen wieder verfestigt haben), eine (oder auch mehrere) weitere thermische Behandlung derselben Bereiche.

Bevorzugterweise erfolgt die thermische Behandlung der Oberfläche/n des Polymerformkörpers durch Kontakt mit einem erhitzten Körper, Gas (z.B. Heißluft) oder Flüssigkeit, oder durch elektromagnetische Strahlung. Ein Fachmann kann das jeweils geeignete Mittel auswählen, um einen definierter Bereich der Oberfläche anzuschmelzen.

Hierbei ist es möglich, die thermische Behandlung entweder nach vorhergehender Erzeugung des Polymerformkörpers, d.h. nachdem der Polymerformkörper das "Formwerkzeug" verlassen hat, oder bereits bei der Herstellung eines solchen Formkörpers im Formwerkzeug, durchzuführen. Es sind bereits Werkzeuge bekannt, bei denen einzelne Teile eines Formkörpers im Werkzeug gezielt erhitzt oder länger heiß gehalten werden können.

Bevorzugterweise wird jedoch elektromagnetische Strahlung zur thermischen Behandlung der Oberfläche des Polymerformkörpers verwendet. Weiter bevorzugt ist es hierbei, Laserstrahlung oder IR-Strahlung, weiter bevorzugt Laserstrahlung, zu verwenden. Hierbei können bekannte Lithographieverfahren zur gezielten Bestrahlung von definierten Bereichen von Substratoberflächen eingesetzt werden. Verfahren zur gezielten Bestrahlung von Oberflächen sind dem Fachmann bekannt und beispielsweise in der EP 0 847 329 A oder WO 02/079881 A

Geeignete Laser für das erfindungsgemäße Verfahren sind: HeNe-Laser, Nd:YAG-Laser, Kohlendioxidlaser (CO₂-Laser), Kohlenmonoxidlaser (CO-Laser), Stickstofflaser (N₂-Laser), Argon-Ionen-Laser, Helium-Cadmium-Laser (HeCd-Laser), Krypton-Ionen-Laser, Sauerstoff-Ionen-Laser, Xenon-Ionen-Laser, Mischgas-Laser (beispielsweise mit Argon und Krypton), Excimerlaser, Metalldampflaser (beispielsweise Kupferdampflaser) und Metallhalogenid-Laser (beispielsweise Kupferbromid-Laser), bevorzugt sind Kohlendioxidlaser (CO₂-Laser) und Nd:YAG-Laser.

Bevorzugterweise wird eine Stelle der Oberfläche des Polymerformkörpers für 0,001 bis 1 Sekunde erhitzt. Die Zeitdauer des Erhitzens bezieht sich hierbei auf die Zeitdauer, in der sich die Oberfläche des Polymerformkörpers in geschmolzenem Zustand befindet. Diese Zeitdauer kann vom Fachmann für die gewünschte Anwendung und die verwendeten Polymere leicht gewählt werden. Insbesondere ist es möglich, durch die Zeitdauer des Erhitzens, in der die Oberfläche angeschmolzen ist, den Oberflächenwiderstand einzustellen. Je länger die Oberfläche angeschmolzen wird und umso tiefer sich der angeschmolzene Bereich in die Oberfläche hinein erstreckt, desto mehr Carbon Nanotubes migrieren an die Oberfläche, wodurch die elektrische Leitfähigkeit der Struktur erhöht wird.

Es ist zusätzlich bevorzugt, dass die Oberfläche des Polymerformkörpers auf eine Temperatur erhitzt wird, die zum Schmelzen der Polymerphase/n ausreicht, jedoch nicht zu einem merklichen Verdampfen der Polymerphase/n führt. Der Ausdruck "merkliches Verdampfen" bedeutet hierbei, dass die erzeugte leitfähige Struktur weniger als 1 Mikrometer, weiter bevorzugt weniger als 500 nm, tief in der Oberfläche des Polymerformkörpers liegt.

Das erfindungsgemäße Verfahren kann insbesondere zur Herstellung von elektronischen Schaltkreisen auf der Oberfläche des Polymerformkörpers verwendet werden. Somit können auf einfache Weise insbesondere sehr kleine Bauteile, beispielsweise als MIDs (moulded interconnected devices) hergestellt werden. Hierbei werden die Polymerformkörper erfindungsgemäß beispielsweise in einem Standard-Spritzgießverfahren als beliebige Formteile hergestellt und anschließend die elektrisch leitfähigen Strukturen erzeugt.

Des Weiteren betrifft die Erfindung einen Polymerformkörper, umfassend mindestens eine Polymerphase und zwischen 0,01 und 10 Gew.-%, bevorzugt zwischen 0,1 und 10 Gew.-%, weiter bevorzugt zwischen 0,1 und 10 Gew.-%, weiter bevorzugt zwischen 0,1 und 8 Gew.-%, und am meisten bevorzugt zwischen 0,1 und 6 Gew.-%. Carbon Nanotubes (CNT) (bezogen auf die Gesamtmasse der Polymerphase/n des Polymerformkörpers), wobei der Polymerformkörper auf der Oberfläche elektrisch oder thermisch, bevorzugt elektrisch, leitfähige Strukturen aufweist, wobei die Konzentration der CNT in den Bereichen der leitfähigen Oberflächenstrukturen höher ist als in den nicht leitfähigen Oberflächenbereichen.

Bevorzugterweise besteht der Polymerformkörper aus den im Vorangegangenen beschriebenen, insbesondere als bevorzugt erwähnten, Polymeren. Insbesondere bevorzugt enthält der Polymerformkörper mindestens eine Polymerphase die ein Polymer enthält, ausgewählt aus der Gruppe bestehend aus: Polycarbonat, Polystryrol, Acrylnitrit-Butadien-Styrol (ABS), Styrolmaleinsäureanhydrid (SMA), Styrolmethylmethacrylat (SMMA), Polymethylmethacrylat (PMMA), Polybutylenterephthalat (PBT), Polyethylenterephthalat (PET), Polyamid 6 (PA 6), Polyamid 6.6 (PA 6.6), Polyamid 6.4 (PA6.4), Polyamid 12 (PA 12), aromatischem Polyamid und Polysulfon, Polypropylen.

Zusätzlich bevorzugt enthält der Polymerformkörper Nanocomposits. Geeignete Nanocomposits und geeignete Mengen wurden im Vorangegangenen beschrieben.

In einer weiteren bevorzugten Ausführungsform der Erfindung weist der Polymerformkörper mindestens zwei getrennte Polymerphasen auf. Besonders bevorzugt enthält der Polymerformkörper mindestens zwei, weiter bevorzugt zwei, Polymerphasen, wobei die eine Polymerphase aus Polymeren besteht, ausgewählt aus der Gruppe bestehend aus Polystyrol (PS), Polymethylmetacrylat (PMMA) und Acrylnitrit-Butadien-Styrol (ABS), sowie thermoplastischen Polyestern, wie Polyethylenterephthalat (PET) oder Polybutylenterephthalat (PBT), und Polycarbonat, sowie Mischungen daraus. Die zweite Polymerphase besteht aus Polypropylen und/oder Polypropylencopolymeren. Alternativ dazu können die beiden Polymerphasen aus Polystyrol und/oder Polyamid-6 in Kombination mit Polyethylen und/oder Polypropylen bestehen. Besonders bevorzugt ist die Verwendung von Polycarbonat in Kombination mit Polyolefinen, insbesondere Polypropylen. Die bevorzugten Mengenanteile der Polypropylen und/oder Polypropylencopolymere sind im Vorangegangenen beschrieben.

Die Analyse des fertiggestellten Polymerformkörpers hinsichtlich der vorhandenen Polymerphase/n ist im Methodenteil beschrieben. Die leitfähigen Strukturen (mit erhöhtem CNT Anteil) auf der Oberfläche des Polymerformkörpers können, wie bereits erwähnt, mit üblichen optischen Messmethoden nachgewiesen werden. Weiter bevorzugt enthält eine der Polymerphasen einen höheren Anteil an Carbon Nanotubes (CNT) als die andere/n Phasen.

Es ist zudem bevorzugt, dass die elektrisch leitfähigen Strukturen des Polymerformkörpers maximal bis 10 µm, bevorzugt maximal bis 1 µm, weiter bevorzugt maximal bis 100 nm in das Innere des Polymerformkörpers (von der äußeren Oberfläche an gerechnet) hineinreichen.

In einer besonders bevorzugten Ausführungsform der Erfindung enthält der Polymerformkörper eine Polypropylenphase und eine Polycarbonatphase, wobei bevorzugterweise zwischen 50 und 80 Gew.-%, weiter bevorzugt zwischen 60 und 80 Gew.-%, und noch weiter bevorzugt zwischen 70 und 80 Gew.-% Polypropylen, bezogen auf die gesamte Masse des Polymergemisches, verwendet werden. Besonders geeignete Polycarbonate können, wie beispielsweise in DE 13 002 66 oder DE 14 957 30 beschrieben, hergestellt werden.

Der erfindungsgemäße Polymerformkörper kann insbesondere so ausgestaltet sein, dass dessen elektrisch leitfähigen Oberflächenstrukturen Leiterbahnen bzw. elektronische Schaltkreise darstellen. Damit kann der Polymerformkörper als Platine in einem elektronischen Bauteil verwendet werden. Auf diese Platine können nach herkömmlichen Verfahren, wie beispielsweise Löten, Schweißen oder Ultraschall-Schweißen, beliebige Bauteile oder (elektronische) Bauelemente aufgebracht werden.

### METHODEN

Zur Bestimmung der Parameter der erfindungsgemäßen Polymerformkörper werden die nachstehenden Methoden eingesetzt:
Die Bestimmung der elektrischen Oberflächenleitfähigkeit erfolgte anhand der Messung des Oberflächenwiderstands mit einem Ohmmeter "Metra Hit Plus" der Firma Gossen Metrawatt GmbH nach Angaben des Herstellers. Es wurde sowohl der Widerstand auf der unbehandelten Oberfläche als auch jeweils an verschiedenen Stellen der mit dem Laser behandelten Oberflächenausschnitte mittels zweier Elektroden im Abstand von 2 mm gemessen. Zum Vergleich wurde die Oberfläche an einer Stelle mechanisch abgetragen und der elektrische Widerstand im Material gemessen.

Die Analyse ob ein Polymerformkörper getrennte Polymerphasen aufweist kann unter Verwendung der Differential-Scanning-Calorimetry (DSC) nach DIN EN ISO 11357 erfolgen. Hierbei kann die Zahl der Polymerphasen anhand der Phasenübergänge beim Schmelzen des Polymerformkörpers festgestellt werden.

Die Bestimmung der Schmelztemperatur der Polymerphasen bzw. des Polymerformkörpers kann gemäß DIN EN ISO 3146 erfolgen.

Der Gesamtgehalt an CNT im Polymerformkörper kann durch das pyrolytische Messverfahren gemäß DIN EN ISO 3451 bestimmt werden.

### BEISPIEL

Es wird eine Polymermischung aus 75 % Polypropylen (Repol HP-12 der Firma Reliance, Indien), 3,75 % CNT (Baytubes C 150 P, Fa. Bayer) und 21,25 Gew.-% Polycarbonat (Makrolon 2805, Fa. Bayer) hergestellt.

Die Mischung wird in einem ZSE 27/44D Doppelschneckenextruder der Firma Leistritz, Nürnberg mit einem Durchmesser von 27 mm und einem Verhältnis L/D von 44 bei einem Durchsatz von 10 kg/h mit einer Leistung von 18 kWh aufgeschmolzen und vermengt. Im Extruder wurde ein von 200°C auf 260°C ansteigendes Temperaturprofil eingestellt. Anschließend erfolgte eine Granulierung.

Der Polymerformkörper wurde im Spritzgussverfahren (Gerätetyp: Arburg 270) bei einer Temperatur von 220-240°C in der Form von runden Plattchen mit 4 cm Durchmesser ausgeformt. Für die thermische Behandlung wurde ein CO₂-Laser verwendet. Die Messwerte der Oberflächenwiderstände sind in der nachfolgenden Tabelle angegeben.

**Tabelle:**

| **Messstelle** | **Oberflächenwiderstand** | | | **Mittelwert** | **Maßeinheit** |
|---|---|---|---|---|---|
| unbehandelt | keine Leitfähigkeit (< 10 MOhm) | | | | |
| Laserspur 2 | 133 | 122 | 146 | 1,34 | kOhm |
| Laserspur 3 | 64,3 | 58,9 | 69,1 | 64,1 | kOhm |
| Laserspur 4 | 23,2 | 21,2 | 24,4 | 22,9 | kOhm |
| abgeschliffen | keine Leitfähigkeit (< 10 MOhm) | | | | |

## Patentansprüche

1. Verfahren zur Erzeugung leitfähiger Strukturen auf der Oberfläche von nicht oder nur gering leitfähigen Polymerformkörpern, umfassend die folgenden Schritte:
a) Bereitstellen eines Polymerformkörpers aus mindestens einer Polymerphase, die Carbon Nanotubes (CNT) enthält;
b) thermische Behandlung mindestens einer Oberfläche des Polymerformkörpers zur Erzeugung der leitfähigen Strukturen auf der Oberfläche des Polymerformkörpers, wobei die thermische Behandlung ein Erhitzen auf eine Temperatur umfasst, die mindestens der Schmelztemperatur der mindestens einen Polymerphase entspricht.

2. Verfahren gemäß Anspruch 1, **dadurch gekennzeichnet, dass** die Polymerphase/n durch Vermischen von geschmolzenem Polymer mit 0,1-10 Gew.-% Carbon Nanotubes, bezogen auf die Masse der Polymerphase/n, erhalten wird/werden.

3. Verfahren gemäß Anspruch 1 oder 2, **dadurch gekennzeichnet, dass** der Polymerformkörper durch Verschmelzen mindestens einer Polymerphase, die Carbon Nanotubes (CNT) in einem Anteil zwischen 1 und 40 Gew.-% enthält, mit mindestens einer weiteren Polymerphase mit geringerem Carbon Nanotubes (CNT)-Anteil, erhalten wird.

4. Verfahren gemäß einem der vorhergehenden Ansprüche, **dadurch gekennzeichnet, dass** die Polymerphase, die Carbon Nanotubes (CNT) in einem Anteil zwischen 1 und 40 Gew.-% enthält, ein oder mehrere Polymer/e umfasst, ausgewählt aus der Gruppe bestehend aus Polycarbonat, Polystryrol, Acrylnitrit-Butadien-Styrol (ABS), Styrolmaleinsäureanhydrid (SMA), Styrolmethylmethacrylat (SMMA), Polymethylmethacrylat (PMMA), Polybutylenterephthalat (PBT), Polyethylenterephthalat (PET), Polyamid 6 (PA 6), Polyamid 6.6 (PA 6.6), Polyamid 6.4 (PA 6.4), Polyamid 12 (PA 12), aromatischem Polyamid und Polysulfon.

5. Verfahren gemäß einem der vorhergehenden Ansprüche, **dadurch gekennzeichnet, dass** die thermische Behandlung der Oberfläche/n des Polymerformkörpers durch Kontakt mit einem erhitzten Körper, Gas oder Flüssigkeit, oder durch elektromagnetische Strahlung erfolgt.

6. Verfahren gemäß einem der vorhergehenden Ansprüche, **dadurch gekennzeichnet, dass** als elektromagnetische Strahlung Laserstrahlung oder IR-Strahlung verwendet wird.

7. Polymerformkörper, umfassend mindestens eine Polymerphase mit Carbon Nanotubes (CNT), wobei der Polymerformkörper auf der Oberfläche elektrisch oder thermisch leitfähige Strukturen aufweist, wobei die Konzentration der CNT in den Bereichen der elektrisch leitfähigen Oberflächenstrukturen höher ist als in den nicht elektrisch leitfähigen Oberflächenbereichen.

8. Polymerformkörper gemäß Anspruch 7, **dadurch gekennzeichnet, dass** mindestens eine Polymerphase ein Polymer enthält, ausgewählt aus der Gruppe bestehend aus: Polycarbonat, Polystryrol, Acrylnitrit-Butadien-Styrol (ABS), Styrolmaleinsäureanhydrid (SMA), Styrolmethylmethacrylat (SMMA), Polymethylmethacrylat (PMMA), Polybutylenterephthalat (PBT), Polyethylenterephthalat (PET), Polyamid 6 (PA 6), Polyamid 6.6 (PA 6.6), Polyamid 6.4 (PA 6.4), Polyamid 12 (PA 12), aromatischem Polyamid und Polysulfon.

9. Polymerformkörper gemäß einem der Ansprüche 7 oder 8, **dadurch gekennzeichnet, dass** zwischen 0,01 und 10 Gew.-% CNT, bezogen auf die Gesamtmasse der Polymerphase/n des Polymerformkörpers, enthalten sind.

10. Polymerformkörper gemäß einem der Ansprüche 7 bis 9, **dadurch gekennzeichnet, dass** der Polymerformkörper mindestens zwei getrennte Polymerphasen enthält.

11. Polymerformkörper gemäß einem der Ansprüche 7 bis 10, **dadurch gekennzeichnet, dass** eine der Polymerphasen einen höheren Anteil an Carbon Nanotubes (CNT) als die andere/n Phasen aufweist.

12. Polymerformkörper gemäß einem der vorstehenden Ansprüche, wobei für den Polymerformkörper eine Polymerblend aus Polycarbonat mit Polyolefin, insbesondere mit Polypropylen oder Polyethylen, verwendet wird.
